# EUROPEAN PATENT APPLICATION

(11) **EP 4 531 101 A1**
(43) Date of publication of application: **02.04.2025**
(21) Application number: 24198636.3
(22) Date of filing: 05.09.2024
(51) Int. Cl.: H01L 23/538, H01L 25/065

(54) **SEMICONDUCTOR PACKAGE**

(30) Priority: 26.09.2023 KR 20230129396
(71) Applicant: Samsung Electronics Co., Ltd., Gyeonggi-do, 16677 (KR)
(72) Inventor: YOO, Byungjoon, 16677 Suwon-si, Gyeonggi-do (KR); SEO, Jungmin, 16677 Suwon-si, Gyeonggi-do (KR); SONG, Kiwhan, 16677 Suwon-si, Gyeonggi-do (KR); LEE, Hanbyeol, 16677 Suwon-si, Gyeonggi-do (KR)
(74) Representative: Kuhnen & Wacker Patent- und Rechtsanwaltsbüro PartG mbB

(57) **Abstract**

A semiconductor package 100 includes a package substrate 110 having a plurality of substrate pads 115, a chip stack ST including a plurality of semiconductor chips 120 stacked on the package substrate 110, each of the plurality of semiconductor chips 120 having a plurality of chip pads 125, and a multichannel film 150 having a plurality of channels respectively connecting the plurality of chip pads 125 of the plurality of semiconductor chips 120 in a stacking direction Z, the plurality of channels electrically connected to the plurality of substrate pads 115.

## Description

### BACKGROUND

The present disclosure relates to a semiconductor package.

As semiconductor devices are miniaturized, high-capacity/high-speed data processing is required. As a method therefor, a semiconductor package having a structure in which a plurality of semiconductor chips are stacked is proposed. However, as the number of stacked semiconductor chips and pads increases, there may be limitations in processing high-capacity data at high speed due to an increase in channel impedance due to an inter-chip connection structure (for example, wirings).

### SUMMARY

Example implementations provide a semiconductor package in which reliability of an electrical connection between a plurality of semiconductor chips may be improved.

An example semiconductor package includes a package substrate having a plurality of substrate pads; a chip stack including a plurality of semiconductor chips stacked on the package substrate, each of plurality of semiconductor chips having a plurality of chip pads; and a multichannel film having a plurality of channels connecting the plurality of chip pads of the plurality of respective semiconductor chips in a stacking direction and having respectively electrically connected to the plurality of substrate pads. The multichannel film includes an insulating film being flexible and having a first surface and a second surface located opposite to each other, a plurality of conductive lines extending on the first surface of the insulating film in the stacking direction, respectively having a portion protruding from the first surface of the insulating film, and respectively provided as the plurality of channels, and an anisotropic conductive film including an adhesive layer disposed on the first surface of the insulating film to cover the plurality of conductive lines, and conductive particles dispersed in the adhesive layer, the conductive particles being disposed between the plurality of conductive lines and the plurality of chip pads and electrically connecting the plurality of conductive lines and the plurality of chip pads.

For example, the chip stack including a plurality of semiconductor chips respectively having a plurality of chip pads arranged along one edge on respective upper surfaces and pad extensions extending from the plurality of chip pads to an adjacent side surface to the one edge. For example, the plurality of semiconductor chips being stacked such that the adjacent side surfaces have a coplanar surface, substantially perpendicular to an upper surface of the package substrate. For example, the insulating film is adhered to the adjacent side surfaces of the plurality of semiconductor chips. For example, the plurality of conductive lines are disposed on an adhered surface of the insulating film and connect the chip pads of the plurality of respective semiconductor chips in the stacking direction.

For example, the chip stack is on a first region of the package substrate. For example, a control chip is on a second region of the package substrate and has a plurality of first pads and a plurality of second pads. For example, a first multichannel film of the multichannel film includes a first insulating film adhered to a side surface of the chip stack and a portion of an upper surface of the control chip, and a plurality of first conductive lines of the plurality of conductive lines disposed on an adhered surface of the first insulating film and connecting the plurality of chip pads of the plurality of respective semiconductor chips to the plurality of first pads respectively. For example, a second multichannel film includes a second insulating film adhered to another portion of the upper surface of the control chip and the package substrate, and a plurality of second conductive lines disposed on an adhered surface of the second insulating film and respectively connecting the plurality of second pads to the plurality of substrate pads.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a perspective view illustrating an example semiconductor package;
FIG. 2 is a cross-sectional view of the semiconductor package illustrated in FIG. 1 taken along line I-I';
FIG. 3 illustrates a side view of a chip stack (in direction "A" in FIG. 1) to which a multichannel film is attached in the semiconductor package illustrated in FIG. 1;
FIG. 4 is a cross-sectional view of the chip stack and the multichannel film illustrated in FIG. 3, taken along line II-II';
FIG. 5 is a plan view illustrating an example semiconductor package;
FIG. 6 is a partial enlarged view illustrating part 'B' of the semiconductor package illustrated in FIG. 5;
FIG. 7 is a perspective view illustrating an example of a multichannel film employable in an implementation;
FIGS. 8A and 8B are cross-sectional views of respective major processes illustrating a process of attaching a multichannel film in an example semiconductor package manufacturing method; and
FIGS. 9 to 11 are cross-sectional views illustrating example semiconductor packages according to various implementations.

### DETAILED DESCRIPTION

Hereinafter, example implementations will be described with reference to the accompanying drawings.

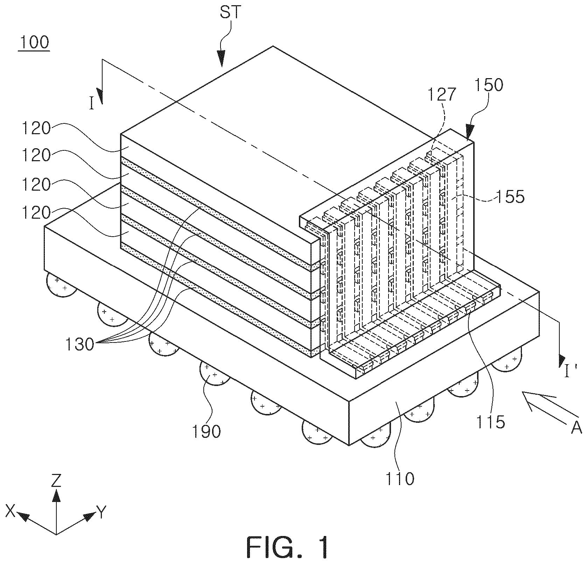

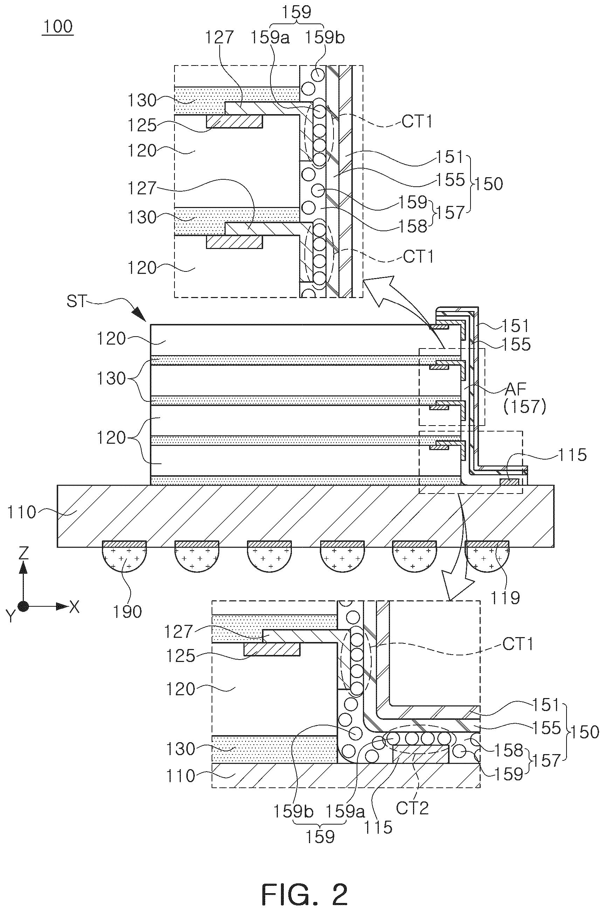

FIG. 1 is a perspective view illustrating a semiconductor package, and FIG. 2 is a cross-sectional view of the semiconductor package illustrated in FIG. 1 taken along line I-I'.

Referring to FIGS. 1 and 2, a semiconductor package 100 according to this implementation may include a package substrate 110, a chip stack ST in which a plurality of semiconductor chips 120 are stacked in a vertical direction (for example, Z-direction) on the package substrate 110, and an adhesive member 130 attached to one side surface of the chip stack ST and extended on the package substrate 110.

The package substrate 110 may include, for example, a printed circuit board (PCB). The package substrate 110 may include substrate pads 115 disposed on the upper surface of the package substrate 110 and connection pads 119 disposed on the lower surface of the package substrate 110. External connection terminals 190 configured to electrically connect an external device and the semiconductor package 100 may be disposed on the connection pads 119. The external connection terminals 190 may be, for example, solder balls or solder pillars.

The chip stack ST may include a plurality of semiconductor chips stacked in a vertical direction (for example, Z-direction) on the package substrate 110. The chip stack ST employed in this implementation is illustrated as including four semiconductor chips, but is not limited thereto. For example, the chip stack ST may include fewer or more semiconductor chips (for example, eight or twelve).

In this implementation, the plurality of semiconductor chips 120 included in the chip stack ST may be of the same type. For example, the plurality of semiconductor chips 120 may be semiconductor memory chips. The memory chip may be, for example, a volatile memory semiconductor chip such as Dynamic Random Access Memory (DRAM) or Static Random Access Memory (SRAM), or a nonvolatile memory semiconductor chips such as Phase-change Random Access Memory (PRAM), Magnetoresistive Random Access Memory (MRAM), Ferroelectric Random Access Memory (FeRAM), or Resistive Random Access Memory (RRAM). In some embodiments, the plurality of semiconductor chips 120 may be flash memory, for example, NAND flash memory. In other embodiments, the plurality of semiconductor chips 120 included in the chip stack ST may include different types of semiconductor chips. For example, some of the semiconductor chips 120 may be logic chips, and other semiconductor chips of the plurality of semiconductor chips 120 may be memory chips. For example, the logic chip may be a central processing unit (CPU) chip, a graphics processing unit (GPU) chip, or an application processor (AP) chip.

As illustrated in FIGS. 1 and 2, the chip pads 125 may be arranged along an edge in an area adjacent to one edge on the upper surface of each semiconductor chip 120. For example, the chip pads 125 of each semiconductor chip 120 may be arranged in the second direction (for example, Y-direction). Chip pads 125 included in each semiconductor chip 120 may be electrically connected to an integrated circuit provided in each semiconductor chip. For example, the integrated circuit may include a memory circuit or a logic circuit.

In some implementations, the plurality of semiconductor chips 120 may have the same dimensions. For example, the plurality of semiconductor chips 120 may have the same horizontal width, vertical width, and thickness. Additionally, the chip pads 125 of the plurality of semiconductor chips 120 may have the same arrangement. For example, in the plurality of respective semiconductor chips 120, the number of chip pads 125 of respective semiconductor chips, the arrangement order of the chip pads 125, the size of the chip pads 125, pitches of the chip pads 125, and the like may be the same.

The stacked semiconductor chips 120 may be bonded by an adhesive member 130. The adhesive member 130 may be provided between adjacent semiconductor chips 120. Similarly, the adhesive member 130 may be disposed between the lower surface of the lowest semiconductor chip among the plurality of semiconductor chips 120 and the upper surface of the package substrate 110 such that the chip stack ST is attached to the package substrate 110. For example, the adhesive member 130 may be a die attach film.

In this implementation, each of the plurality of semiconductor chips 120 is as illustrated in FIG. 2, and includes a plurality of pad extensions 127 extending from the plurality of chip pads 125 to a side adjacent to the one edge.

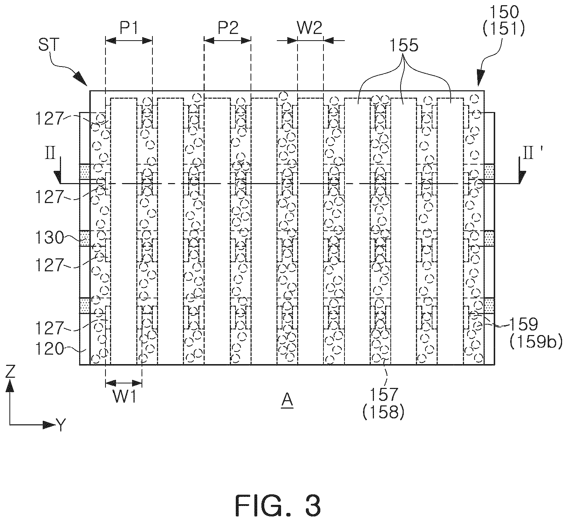

The plurality of semiconductor chips 120 may be stacked such that adjacent side surfaces of the semiconductor chips 120 are substantially coplanar. Referring to FIG. 3, on the side surface of the chip stack ST, some of the plurality of pad extensions 127 may be located on adjacent side surfaces. As illustrated in FIGS. 1 and 2, the semiconductor chips 120 employed in this implementation have the same size, and all sides of the chip stack ST may be provided as side surfaces perpendicular to the upper surface of the package substrate 110.

In this manner, by stacking the semiconductor chips 120, the area occupied by the chip stack ST may be reduced, and further, the size of the semiconductor package 100 may also be reduced.

Referring to FIGS. 1 and 2, the connection between chip pads 125 may be implemented by a multichannel film 150 attached to the side surface of the chip stack ST.

The multichannel film 150 may provide a plurality of channels by connecting the pad extensions 127 located on the chip stack ST in the stacking direction (for example, Z-direction). In this implementation, the multichannel film 150 may extend on the package substrate 110 to be electrically connected to the plurality of substrate pads 115.

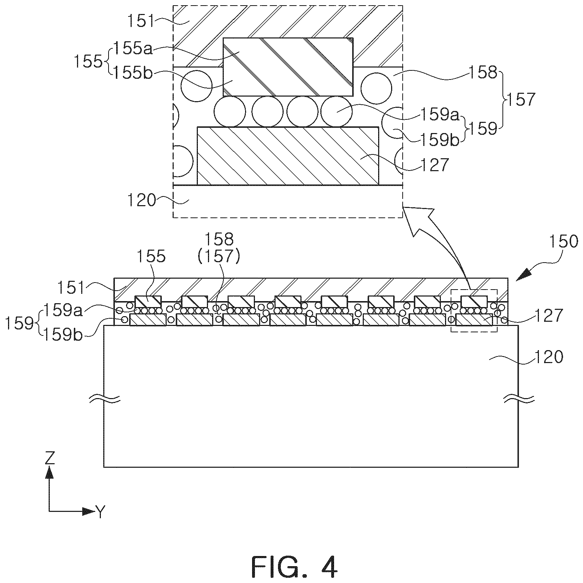

FIGS. 3 and 4 are partial enlarged views for explaining the connection between chip pads by the multichannel film 150 attached to the chip stack ST. FIG. 3 illustrates a side view of the chip stack (direction "A" in FIG. 1) to which the multichannel film is attached in the semiconductor package illustrated in FIG. 1, and FIG. 4 is a cross-sectional view of the chip stack and the multichannel film illustrated in FIG. 3 taken along line II-II'.

Referring to FIGS. 3 and 4 along with FIG. 2, the multichannel film 150 employed in this implementation includes a flexible insulating film 151 having a first surface (for example, an inner surface to be glued) and a second surface (for example, an outer surface) located opposite to each other, a plurality of conductive lines 155 each extending in the stacking direction (for example, Z-direction) on the first surface of the insulating film 151 and arranged in the width direction of the insulating film 151, and an anisotropic conductive film 157 disposed on the first surface of the insulating film 151 to cover the plurality of conductive lines 155.

Each of the plurality of conductive lines 155 may form the same channel by electrically connecting the pad extensions 127 of the semiconductor chips 120 in the stacking direction. In some implementations, the semiconductor chips 120 may be NAND flash memory. In this case, the channel may refer to a collection of signals used in NAND flash memory. In this manner, the chip pads 125 of the same channel of semiconductor chips at different positions are electrically connected by the conductive lines 155 of the multichannel film 150, and respective conductive lines may provide multiple channels.

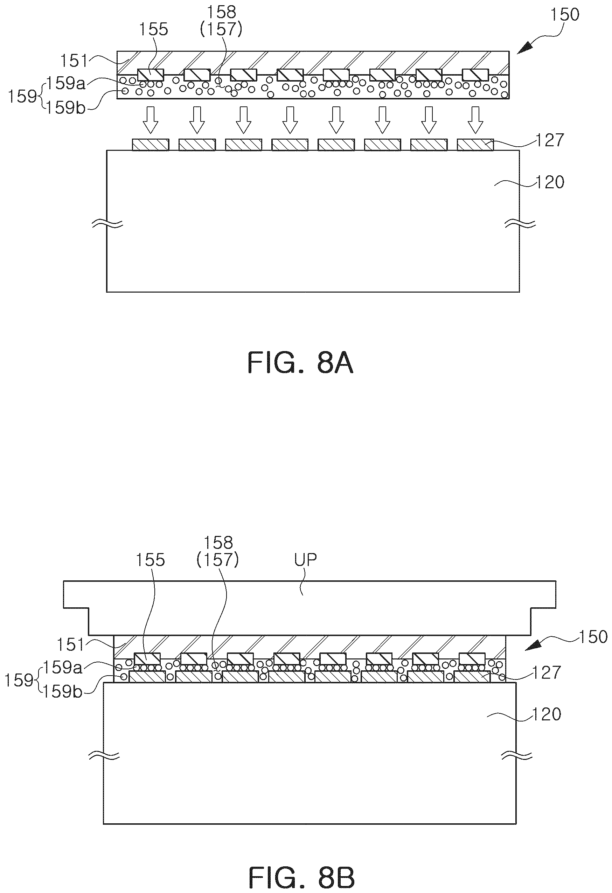

Referring to FIG. 4, a plurality of conductive lines 155 may be partially impregnated into the insulating film 151. The plurality of conductive lines 155 may have a portion 155a embedded in the insulating film 151 and a portion 155b protruding from the first surface of the insulating film 151. This protruding portion 155b may be used as a structure for electrical connection between the conductive lines 155 and the pad extension 127 in the bonding process using the multichannel film 150 (see FIGS. 8A and 8B). Similarly, each of the plurality of pad extensions 127 may have a portion protruding from the adjacent side (see FIG. 4).

The anisotropic conductive film 157 may be configured to provide adhesive force to the multichannel film 150 and realize selective electrical connection between the plurality of conductive lines 155 and the pad extension 127. In this implementation, referring to FIGS. 2 and 4, the anisotropic conductive film 157 (also identified as AF in the middle section of FIG. 2) includes an adhesive layer 158 disposed on the first surface of the insulating film 151 to cover the plurality of conductive lines 155, and conductive particles 159 dispersed in the adhesive layer 158. Portions 159a of the conductive particles 159 may electrically connect the plurality of conductive lines 155 and the pad extension 127. In some implementations, the insulating film 151 may include an insulating resin having flexibility such as polyimide.

In detail, in the state where the multichannel film 150 is attached (see FIGS. 2 and 4), conductive particles 159 may be divided into first conductive particles 159a located between the plurality of conductive lines 155 and the plurality of pad extensions 127, and second conductive particles 159b dispersed in different positions within the adhesive layer 158. The first conductive particles 159a (also shown as CT1 in FIG. 2) may be used to electrically connect the plurality of conductive lines 155 and the plurality of pad extensions 127.

The bonding process using the multichannel film 150 may be performed, for example, by thermocompression bonding or ultrasonic bonding. In some implementations, the adhesive layer 158 may include various curing resins, such as thermosetting resins and ultraviolet curing resins. For example, the adhesive layer 158 may include at least one of epoxy resin, polyurethane, acrylic resin, polyethylene, silicone polymer, styrene butadiene block copolymer, or styrene-ethylene-propylene-styrene block copolymer. The conductive particles 159 may include, for example, metal or eutectic metal balls such as gold (Au), silver (Ag), or nickel (Ni) with a diameter of about 1 µm to about 50 µm, or about 2 µm to about 30 µm. In some implementations, the conductive particles 159 may be provided in various particle shapes, such as carbon fibers, even if they are not spherical.

The multichannel film 150 employed in this implementation may be attached in close contact with one side surface of the chip stack ST by the anisotropic conductive film 157, particularly the adhesive layer 158. As illustrated in FIG. 2, since the conductive lines 155 connecting the pad extensions 127 in the stacking direction are attached to the side surface of each semiconductor chip 120 by the adhesive layer 158 in the area between the pad extensions 127, in this implementation, unnecessary inductance elements due to the lifted curved portion of the bonding wire of the related art may be avoided. Therefore, bonding using the multichannel film 150 according to this implementation may significantly improve the inductance by reducing the length of channels. As a result, the input/output performance of transmitting and receiving large amounts of data at high speed may be greatly improved.

Referring to FIG. 3, the plurality of conductive lines 155 may be arranged at a pitch P2 that is substantially the same as the pitch P1 of the plurality of chip pads 125. Similarly, the plurality of pad extensions 127 may also be arranged at the same pitch. As such, in this implementation, instead of using the related art of wire bonding, channels between chip pads 125 (or pad extensions 127) may be formed more easily and precisely using the conductive lines 155 of the multichannel film 150. Accordingly, in this implementation, the pitch of the chip pads 125 (or the pad extension 127) may be further reduced. For example, the pitch of the plurality of chip pads 125 and the plurality of conductive lines 155 may be 150 µm or less, or 100 µm or less.

In this implementation, each of the plurality of conductive lines 155 may have a width W2 that is equal to or smaller than the width W1 of each of the plurality of pad extensions 127. By providing a smaller width of the plurality of conductive lines 155, more precise alignment may be obtained during the attachment process of the multichannel film 150. Although not limited thereto, for example, the width (for example, width in the Y-direction) of the chip pad 125 may range from 10 µm to 70 µm, and the pad extension 127 may have a width W1 that is the same or similar to that of the chip pad 125. For example, the width W2 of the conductive lines 155 may range from 10 µm to 50 µm.

In this implementation, the multichannel film 150 extends on the package substrate 110, each of the plurality of conductive lines 155 may be electrically connected to the plurality of substrate pads 115 through an anisotropic conductive film 157.

In detail, as described above, referring to FIG. 2, the plurality of conductive lines 155 and the plurality of substrate pads 115 may be electrically connected by the conductive particles 159 dispersed in the anisotropic conductive film 157. In detail, the adhesive layer 158 is pressed while the multichannel film 150 is attached, and the first conductive particles 159a located between the protruding conductive lines 155 and the protruding substrate pads 115 may electrically connect the plurality of conductive lines 155 and the plurality of pad extensions 127 to each other unlike other second conductive particles 159b.

The multichannel film 150 employed in this implementation is composed of materials such as the insulating film 151, the conductive lines 155 and the anisotropic conductive film 157 and may thus have sufficient flexibility. Therefore, as illustrated in FIG. 2, the multichannel film 150 may be easily attached to extend to the upper surface of the package substrate 110 over the angled area in which the side surface of the chip stack ST and the upper surface of the package substrate 110 meet.

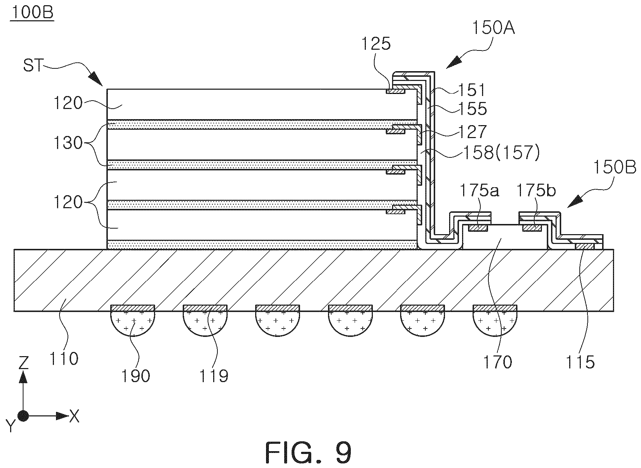

In some implementations, the package substrate 110 includes a wiring layer connected to substrate pads 115, and the semiconductor package 100 may include an additional semiconductor chip disposed on the package substrate 110 and electrically connected to the wiring layer. The additional semiconductor chip may include a control chip 170 (for example, control chip 170 in FIG. 9) configured to control the operation of the semiconductor chips 120 included in the chip stack ST.

The structure of the multichannel film according to this implementation, especially the anisotropic conductive film, may be changed into various forms.

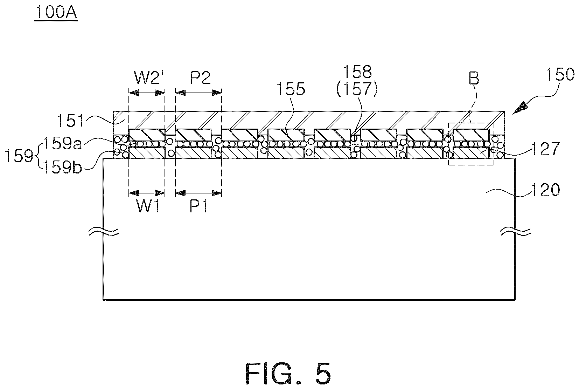

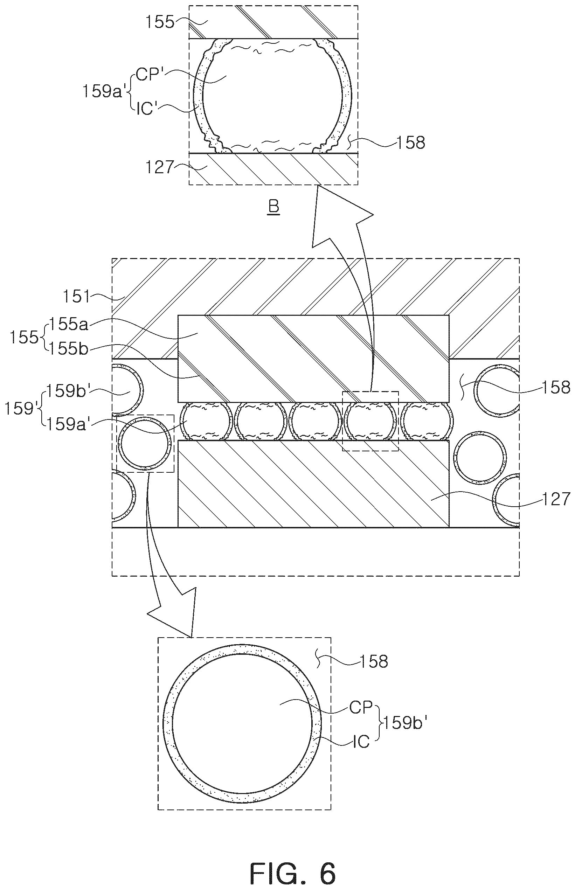

FIG. 5 is a plan view illustrating a semiconductor package, and FIG. 6 is a partial enlarged view illustrating part 'B' of the semiconductor package illustrated in FIG. 5. In this case, FIG. 5 may be understood as illustrating a portion corresponding to FIG. 4.

Referring to FIGS. 5 and 6, a semiconductor package 100A according to this implementation may be understood as a structure similar to the semiconductor package 100 illustrated in FIGS. 1 to 4, except that each conductive line 155 has a width substantially the same as the width of the pad extension 127, and the composition of the conductive particles 159 of the anisotropic conductive film 157 is different. Accordingly, the description of the example implementation illustrated in FIGS. 1 to 4 may be combined with the description of the present implementation, unless there is a specific explanation to the contrary.

Referring to FIG. 5, the conductive lines 155 have a pitch that is substantially the same as that of the pad extension 127, but the width of the conductive lines 155 may be appropriately changed. In this implementation, the conductive lines 155 may have a width substantially the same as the width of the pad extension 127.

Referring to FIG. 6, the conductive particles 159 employed in this implementation may include a core metal (CP) and an insulating coating (1C) surrounding the surface. The conductive particles 159 may include first conductive particles 159a between the plurality of conductive lines 155 and the plurality of pad extensions 127, and second conductive particles 159b located in another area of the adhesive layer 158.

As such, in this implementation, the first conductive particles 159a are conductive particles for contact and are compressed by the plurality of conductive lines 155 and the plurality of pad extensions 127, especially by protruding portions thereof, and the insulating coating (IC') is at least partially destroyed, and the core metal (CP') is exposed in the pressing direction and may act as a contact element. On the other hand, even if the second conductive particles 159b aggregate within the adhesive layer 158 and come into contact with other contact elements, they may not cause a short circuit problem due to the insulating coating (IC).

In this implementation, the bonding process using the multichannel film 150 may be easily implemented as in the related art bonding (for example, wire bonding).

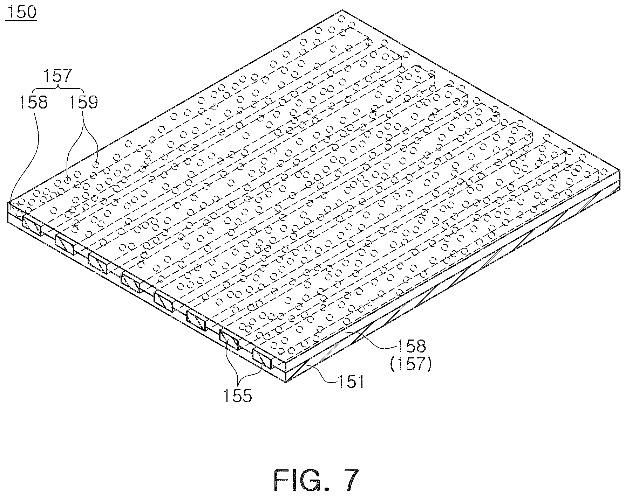

FIG. 7 is a perspective view illustrating an example of a multichannel film employable in an implementation, and FIGS. 8A and 8B are cross-sectional views of each major process illustrating the process of attaching a multichannel film in the semiconductor package manufacturing method according to this implementation.

Referring to FIG. 7, the multichannel film 150 according to this implementation is illustrated with the anisotropic conductive film 157, for example, the adhered surface facing upward.

The multichannel film 150 includes a plurality of conductive lines 155 provided in a plurality of channels. The plurality of conductive lines 155 extend in the length direction of the multichannel film 150 and are arranged at a constant pitch in the width direction. As previously described, the pitch of the plurality of conductive lines 155 is arranged to be substantially the same as the pitch of the pad extensions 127 (or chip pads 125). In some implementations, the width of the conductive lines 155 may be equal to or smaller than the width of the pad extensions 127 (or chip pads 125).

The plurality of conductive lines 155 are partially impregnated into the insulating film 151, and have a portion protruding from one side surface of the insulating film 151. In the process of pressing the multichannel film 150, the protruding portions of the plurality of conductive lines 155 may be used as a structure to more easily implement contact with the anisotropic conductive film 157. An anisotropic conductive film 157 may be provided to cover a plurality of conductive lines 155 on one side surface of the insulating film 151. The anisotropic conductive film 157 may include an uncured adhesive layer 158 and conductive particles 159 dispersed in the adhesive layer 158.

The multichannel film 150 according to this implementation may include an insulating film 151 and an adhesive layer 158 having sufficient flexibility and relatively thin conductive lines 155, and so may be easily attached to non-flat surfaces such as protruding structures (for example, chip stack ST and pad extension 127).

Referring to FIG. 8A along with FIGS. 1 and 2, the multichannel film 150 of FIG. 7 is aligned on the chip stack, for example, on the side surface of the semiconductor chips 120. In this case, the conductive lines 155 of the multichannel film 150 may be aligned to be located on the pad extensions 127 of the semiconductor chips 120. The alignment error may be compensated by making the width of the conductive lines 155 somewhat smaller than the width of the pad extension 127.

Next, referring to FIG. 8B, a multichannel film is attached on the side surface of the chip stack. Attachment of the multichannel film 150 may be performed, for example, by thermocompression bonding or ultrasonic bonding. As illustrated in FIG. 8B, ultrasonic vibration may be applied to the multichannel film 150 in close contact using an ultrasonic compression device (UP). This ultrasonic vibration induces the conductive particles 159 to be located between the plurality of conductive lines 155 and the plurality of pad extensions 127. A stable contact may be obtained by melting the first conductive particles 159a between the plurality of conductive lines 155 and the plurality of pad extensions 127 without a separate heating process. In this manner, the conductive particles 159a may contact the plurality of conductive lines 155 and the plurality of pad extensions 127 (or chip pads 125), in the compression direction between the plurality of conductive lines 155 and the plurality of pad extensions 127 (or chip pads 125). The curing process of the adhesive layer 158 may be performed in parallel with this pressing process or through a separate process. As a result, the multichannel film 150 is stably attached to the side surface of the chip stack (semiconductor chip 120), and each of the conductive lines 155 may form desired channels by connecting pad extensions 127 (or chip pads 125) of the semiconductor chips 120 in the stacking direction.

The multichannel film 150 may be connected to the substrate pads 115 on the package substrate 110 using an additional pressing process. As a result, the multichannel film 150 may provide channels extending from the pad extensions 127 (or chip pads 125) of the semiconductor chips 120 to the substrate pads 115.

The multichannel film 150 may be used not only to connect the semiconductor chips 120 of the chip stack ST and the package substrate 110, but also to connect them with the control chip 170, which is a processor.

FIG. 9 is a cross-sectional view illustrating an example semiconductor package.

Referring to FIG. 9, a semiconductor package 100B according to this implementation may be understood as a structure similar to the semiconductor package 100 illustrated in FIGS. 1 to 4, except that a control chip 170 is additionally disposed on the package substrate 110 and the multi-channel film includes a first multichannel film 150A and a second multichannel film 150B for connection to the control chip 170. Accordingly, the description of the examples illustrated in FIGS. 1 to 4 may be combined with the description of the present implementation, unless there is a specific explanation to the contrary.

The chip stack ST in which the semiconductor chips 120 are stacked may be disposed on the first region of the package substrate 110, and the control chip 170 driving the semiconductor chips 120 may be disposed in the second region of the package substrate 110. The control chip 170 includes a plurality of first pads 175a and a plurality of second pads 175b. A plurality of first pads 175a are arranged along an edge area adjacent to the chip stack ST on the upper surface of the control chip 170, and the plurality of second pads 175b may be arranged along another edge area opposite to the edge area on the upper surface of the control chip 170. A plurality of substrate pads 115 may be arranged on the package substrate 110 adjacent to the edge area in which the plurality of second pads 175b are arranged.

The semiconductor package 100 according to this implementation may include a first multichannel film 150A connecting the chip pads 125 of the chip stacks ST and the first pads 175a of the control chip 170, and a second multichannel film 150B connecting the second pads 175b of the control chip 170 and the substrate pads 115.

The first multichannel film 150A may include an insulating film 151 adhered to a portion of the upper surface of the control chip 170 and the side surface of the chip stack ST and a plurality of conductive lines 155 disposed on the adhered surface of the insulating film 151 and connecting the plurality of chip pads 125 of each of the plurality of semiconductor chips 120 and the plurality of first pads 175a.

Similar to the first multichannel film 150A, the second multichannel film 150B may include an insulating film 151 adhered to another portion of the upper surface of the control chip 170 and the package substrate 110, and a plurality of conductive lines 155 disposed on the adhered surface of the insulating film 151 and connecting the plurality of second pads 175b to the plurality of substrate pads 115.

At least one of the first and second multichannel films may further include an adhesive layer 158 provided on the adhered surface of the insulating film 151. As described in the previous implementations, the adhesive layer 158 may be provided as an anisotropic conductive film 157 in which conductive particles 159 are dispersed within the adhesive layer 158. In this case, each of the plurality of conductive lines 155 may have a portion protruding from the adhered surface of the insulating film 151 (see FIG. 4).

The semiconductor package according to this implementation may not use a chip stack with vertical sides, and in some implementations, chip pads may be directly connected without a pad extension, which may be implemented in various ways.

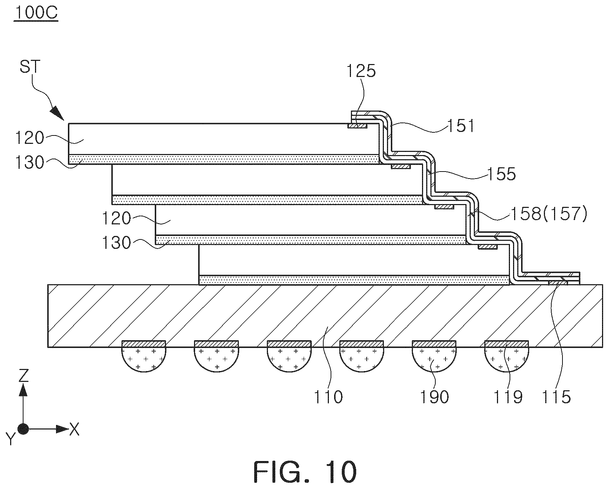

FIG. 10 is a cross-sectional view illustrating a semiconductor package.

Referring to FIG. 10, a semiconductor package 100C according to this implementation may be understood as a structure similar to the semiconductor package 100 illustrated in FIGS. 1 to 4, except that the semiconductor chips 120 are stacked in a step shape and the multichannel film 150 is directly connected to the chip pads 125 without a pad extension. Accordingly, the description of the example implementation illustrated in FIGS. 1 to 4 may be combined with the description of the present implementation, unless there is a specific explanation to the contrary.

The plurality of semiconductor chips 120 included in the chip stack ST may be stacked sequentially offset in one direction. For example, the semiconductor chips 120 may be sequentially stacked such that one portion protrudes in one direction from the semiconductor chip 120 disposed below. For example, the plurality of semiconductor chips 120 may be stacked in steps, as illustrated in FIG. 10. In this stepped chip stack ST, an offset distance may be set such that the chip pads 125 located on the upper surface of each semiconductor chip 120 are exposed. Therefore, the chip pads 125 may be directly bonded without a pad extension.

In this implementation, the multichannel film 150 may be arranged along one side surface of the chip stack ST to form a plurality of channels by connecting the chip pads 125 in the stacking direction. As described above, the multichannel film 150 has sufficient flexibility, and may thus be bent along the step structure of the chip stack. This multichannel film 150 not only requires a simpler process compared to the related art of wire bonding, but also may suppress an increase in inductance by providing a channel with a short conductive path.

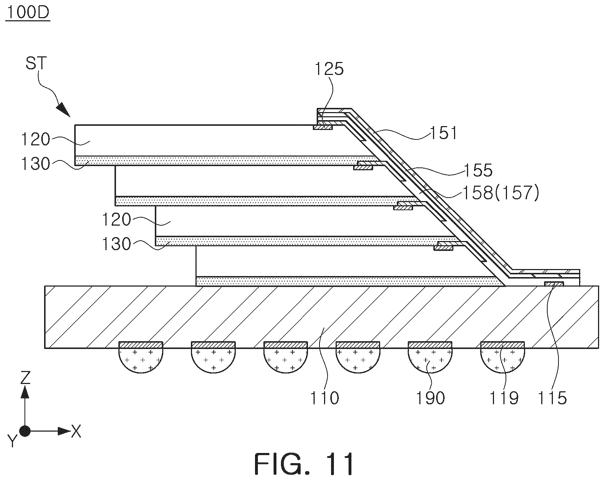

FIG. 11 is a cross-sectional view illustrating an example semiconductor package.

Referring to FIG. 11, a semiconductor package 100D according to this implementation may be understood as a structure similar to the semiconductor package 100 illustrated in FIGS. 1 to 4, except that the sides of the semiconductor chips 120 have inclined sides, and the multichannel film 150 is disposed along the inclined sides. Accordingly, the description of the example implementation illustrated in FIGS. 1 to 4 may be combined with the description of the present implementation, unless there is a specific explanation to the contrary.

Each of the plurality of semiconductor chips 120 includes chip pads 125 arranged along one edge of the upper surface of each of the plurality of semiconductor chips 120. The plurality of semiconductor chips 120 may have an inclined surface in which the side surface adjacent to an area in which the chip pads 125 are arranged faces upwardly. In this implementation, at least the other opposing side may have an oppositely inclined side surface, but the present inventive concept is not limited thereto. A plurality of pad extensions 127 may extend from the plurality of chip pads 125 along the inclined side surface.

In this implementation, the plurality of semiconductor chips 120 may be arranged such that each adjacent inclined side surface has substantially one inclined coplanar surface. The multichannel film 150 is bonded along the inclined coplanar surface, and conductive lines 155 may connect the pad extensions 127 to form desired channels. The channel path according to this implementation may be provided in a relatively shortest path by being in close contact with the side surface of the chip stack ST, similar to the channel path of the semiconductor package 100 illustrated in FIG. 2, and may effectively reduce the inductance.

As set forth above, according to example implementations, by bonding chip pads of stacked semiconductor chips in a stacking direction using a multichannel film, the inductance due to the bonding wire may be significantly reduced and a design to further reduce the pitch (for example, 150µm or less) of chip pads may be enabled. In an example implementation, the pad extension connected to respective chip pads may be formed on side surfaces of the semiconductor chips, and the semiconductor chips may be stacked such that the side surfaces of the semiconductor chips are coplanar, thereby further increasing the effect of a multichannel film and also reducing a package area.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor package (100) comprising:
a package substrate (110) having a plurality of substrate pads (115);
a chip stack (ST) including a plurality of semiconductor chips (120) stacked on the package substrate (110), each of the plurality of semiconductor chips (120) having a plurality of chip pads (125); and
a multichannel film (150) having a plurality of channels respectively connecting the plurality of chip pads (125) of the plurality of semiconductor chips (120) in a stacking direction (Z), the plurality of channels electrically connected to the plurality of substrate pads (115),
wherein the multichannel film (150) includes,
an insulating film (151) having a first surface and a second surface located opposite to each other,
a plurality of conductive lines (155) extending on the first surface of the insulating film (151) in the stacking direction (Z), respectively having a portion (155b) protruding from the first surface of the insulating film (151), and respectively provided as the plurality of channels, and
an anisotropic conductive film (157) including an adhesive layer (158) on the first surface of the insulating film (151) to cover the plurality of conductive lines (155), and conductive particles (159) dispersed in the adhesive layer (158), the conductive particles (159) being disposed between the plurality of conductive lines (155) and the plurality of chip pads (125) and electrically connecting the plurality of conductive lines (155) and the plurality of chip pads (125).

2. The semiconductor package (100) of claim 1, wherein the plurality of chip pads (125) are arranged along one edge of an upper surface of each of the plurality of semiconductor chips (120), and
each of the plurality of semiconductor chips (120) further includes a plurality of pad extensions (127) extending from the plurality of chip pads (125) to an adjacent side surface to the one edge.

3. The semiconductor package (100) of claim 2, wherein each of the plurality of pad extensions (127) has a portion protruding from the adjacent side surface.

4. The semiconductor package (100) of claim 2 or 3, wherein the plurality of semiconductor chips (120) are stacked such that the adjacent respective side surfaces are substantially coplanar with each other.

5. The semiconductor package (100) of claim 4, wherein the adjacent side surfaces of each of the plurality of semiconductor chips (120) have a surface perpendicular to the upper surface.

6. The semiconductor package (100) of claim 4, wherein the substantially coplanar adjacent side surfaces of each of the plurality of semiconductor chips (120) form an upward inclined surface.

7. The semiconductor package (100) of any one of claims 1 to 6, wherein the multichannel film (150) extends to the plurality of substrate pads (115), and the plurality of conductive lines (155) are electrically connected to the plurality of substrate pads (115) by the anisotropic conductive film (157).

8. The semiconductor package (100) of any one of claims 1 to 7, further comprising a control chip (170) disposed on the package substrate (110) and having a plurality of first pads (175a) and a plurality of second pads (175b).

9. The semiconductor package (100) of claim 8, wherein the multichannel film (150) extends to the control chip (170), and the plurality of conductive lines (155) are electrically connected to the plurality of first pads (175a) by the anisotropic conductive film (157).

10. The semiconductor package (100) of claim 8 or 9, wherein the plurality of second pads (175b) of the control chip (170) are electrically connected to the plurality of substrate pads (115).

11. The semiconductor package (100) of any one of claims 1 to 10, wherein the conductive particles (159) include an insulating coating (IC) surrounding a core metal (CP), and
the conductive particles (159) include conductive particles (159) for contact disposed between the plurality of conductive lines (155) and the plurality of chip pads (125), and the insulating coating (IC) is present on a surface region of the conductive particles (159) except where the conductive lines (155) are in electrical contact with the plurality of chip pads (125).

12. The semiconductor package (100) of any one of claims 1 to 11, wherein the plurality of conductive lines (155) are arranged at substantially a same pitch (P1, P2) as the plurality of chip pads (125).

13. The semiconductor package (100) of any one of claims 2 to 12, wherein each of the plurality of conductive lines (155) has a width (W2) equal to or smaller than a width (W1) of each of the plurality of pad extensions (127).

14. The semiconductor package (100) of any one of claims 1 to 13, wherein the plurality of chip pads (125) are arranged at a pitch (P1) of 150 µm or less along one edge of an upper surface of each of the plurality of semiconductor chips (120).

15. The semiconductor package (100) of any one of claims 1 to 14, wherein each of the plurality of semiconductor chips (120) is a semiconductor memory chip.
